(19) Europäisches Patentamt
European Patent Office
Office européen des brevets

(11) Veröffentlichungsnummer: **0 021 086**
**B1**

(12) # EUROPÄISCHE PATENTSCHRIFT

(45) Veröffentlichungstag der Patentschrift: **18.05.83**

(51) Int. Cl.[3]: **H 01 L 31/10,** H 01 L 27/14

(21) Anmeldenummer: **80102973.7**

(22) Anmeldetag: **28.05.80**

(54) **Lichtsteuerbare Anordnung.**

(30) Priorität: **31.05.79 DE 2922301**

(43) Veröffentlichungstag der Anmeldung: **07.01.81 Patentblatt 81/1**

(45) Bekanntmachung des Hinweises auf die Patenterteilung: **18.05.83 Patentblatt 83/20**

(84) Benannte Vertragsstaaten: **CH FR GB IT LI**

(56) Entgegenhaltungen: **DE-A-2 039 869**

(73) Patentinhaber: **SIEMENS AKTIENGESELLSCHAFT, Berlin und München Wittelsbacherplatz 2, *D-8000 München 2 (DE)***

(72) Erfinder: **Tihanyi, Jenö, Dr. Dipl.-Phys., Wolfratshauser Strasse 179 b, D-8000 München 71 (DE)**

**EP 0 021 086 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

# Lichtsteuerbare Anordnung

Die Erfindung bezieht sich auf eine lichtsteuerbare Anordnung aus einem in einen Halbleiterkörper integrierten Thyristor mit einer anodenseitigen und einer katodenseitigen Emitterzone und zwei zwischen den Emitterzonen liegenden Innenzonen, und aus einer in den Halbleiterkörper integrierten, durch Licht steuerbaren stromverstärkenden Anordnung, deren Ausgang mit dem Steuereingang des Thyristors verbunden ist, wobei mindestens die katodenseitige Emitterzone durch einen Nebenschluss elektrisch mit der angrenzenden inneren Zone verbunden ist.

Ein solcher Thyristor ist bereits beschrieben worden. Bei Thyristoren dieser Art besteht im allgemeinen das Problem, dass eine sichere Zündung bereits mit geringen Lichtmengen erreicht werden soll. Beim bekannten Thyristor ist daher ein Hilfsthyristor in den Halbleiterkörper des Thyristors integriert, der den Steuerstrom für den den Laststrom schaltenden Thyristor liefert. Der Hilfsthyristor muss sehr empfindlich sein, um bereits bei geringen Lichtmengen einen für die Zündung des Thyristors ausreichenden Strom zu liefern. Hohe Lichtempfindlichkeit des Hilfsthyristors bringt jedoch eine hohe Empfindlichkeit gegen du/dt-Beanspruchungen mit sich. Beim bekannten Thyristor wird eine gute du/dt-Festigkeit und gleichzeitig eine relativ hohe Lichtempfindlichkeit durch einen speziell ausgebildeten Nebenschluss im Hilfsthyristor erreicht.

Der Erfindung liegt die Aufgabe zugrunde, einen lichtsteuerbaren Thyristor der eingangs erwähnten Art so weiterzubilden, dass die Lichtempfindlichkeit und die du/dt-Festigkeit praktisch voneinander unabhängig einstellbar sind.

Die Erfindung ist dadurch gekennzeichnet, dass die durch Licht steuerbare stromverstärkende Anordnung aus einem Fototransistor und einem Feldeffekttransistor besteht, dessen Gateeingang mit dem Ausgang des Fototransistors verbunden ist. Weiterbildungen sind Gegenstand der Unteransprüche.

Die Erfindung wird an Hand von Ausführungsbeispielen in Verbindung mit den Fig. 1 bis 4 näher erläutert. Es zeigen:

Fig. 1 das Prinzipschaltbild der Erfindung,

Fig. 2 den Schnitt durch einen lichtempfindlichen Thyristor gemäss einem ersten Ausführungsbeispiel,

Fig. 3 den Schnitt durch ein zweites Ausführungsbeispiel des Fototransistors, und

Fig. 4 ein drittes Ausführungsbeispiel des Fototransistors.

In Fig. 1 ist der Fototransistor mit FT, der Feldeffekttransistor mit FET und der Thyristor mit Th bezeichnet. Der Kollektor des Fototransistors FT ist mit der Anodenspannung $U_a$ verbunden. Der Emitter des Fototransistors ist über einen Widerstand $R_g$ entweder mit der katodenseitigen Emitterzone 3 des Thyristors oder mit der katodenseitigen inneren Zone 2 des Thyristors verbunden. Der Ausgang des Fototransistors ist derart mit dem Gateeingang G des FET verbunden, dass die am Widerstand $R_g$ abfallende Spannung zwischen Steuereingang G und Source S des FET liegt. Die eingezeichneten Kondensatoren $C_B$, $C_C$, $C_D$, $C_G$ bezeichnen die Kollektor-Bass-Kapazität und die Kollektor-Emitter-Kapazität des Fototransistors beziehungsweise die zwischen Gateeingang und Source und die zwischen Gateeingang und Drain des FET liegenden Kapazitäten. Die Drainzone D des FET, das heisst sein Ausgang, ist mit der anodenseitigen Mittelzone 1 des Thyristors, das heisst mit seinem Eingang, verbunden. Zumindest zwischen der Emitterzone 3 und der angrenzenden Innenzone 2 liegt ein das du/dt-Verhalten des Thyristors bestimmender Widerstand, der mit R 2 bezeichnet ist. Zur weiteren Verbesserung kann auch zwischen der anodenseitigen Emitterzone 11 und der angrenzenden Innenzone 1 ein weiterer Nebenschluss liegen, der durch den Widerstand R 1 symbolisiert ist. Die Anordnung kann auch so modifiziert sein, dass die Kapazität $C_C$ nicht zwischen Kollektor und Emitter des Fototransistors, sondern zwischen Kollektor des Fototransistors und Sourcezone S des FET liegt, wie durch die gestrichelte Verbindung angedeutet ist. Der Emitter des Fototransistors bleibt jedoch mit dem Steuereingang des FET verbunden.

Fällt auf den Emitter des Fototransistors FT Licht, zieht dieser Strom und im Widerstand $R_g$ wird ein Spannungsabfall erzeugt. Bei der eingezeichneten Thyristorspannung wird die Sourcezone S entweder über die Innenzone 2 und den Widerstand R 2 oder gemäss der Alternative direkt über die Emitterzone 3 gegenüber dem Gateanschluss G des FET negativ vorgespannt und der FET wird eingeschaltet. Damit fliessen negative Ladungsträger in die anodenseitige Innenzone 1. Dies regt eine Emission von positiven Ladungsträgern aus der anodenseitigen Emitterzone 11 in die Innenzone 1 an. Diese Ladungsträger diffundieren zum pn-Übergang zwischen den Innenzonen 1 und 2. Damit wird dieser pn-Übergang in Durchlassrichtung vorgespannt und der Thyristor zündet.

Um eine möglichst hohe Unempfindlichkeit gegen hochfrequente Störimpulse zu erreichen, empfiehlt es sich, die Grösse der Kapazitäten in folgendes Verhältnis zu setzen:

$$C_B << C_C << C_G \text{ und } C_D < C_G.$$

Dies wird durch eine geeignete Dimensionierung der Anordnung erreicht.

Die dargestellte Anordnung ist extrem lichtempfindlich, da der Fototransistor nur so viel Strom liefern muss, dass die Gatespannung des FET über die Einsatzpannung erhöht wird. Dieser von der Grösse des Widerstandes $R_g$ abhängige Strom kann extrem klein sein, da der FET selbst einen sehr hohen Eingangswiderstand hat und so die Empfindlichkeit gegenüber einfallendem Licht wesentlich höher wird als bei bisher verwendeten Lösungen. Auf der anderen Seite ist die Empfindlichkeit des Thyristors gegen du/dt-Belastungen durch Wahl der Widerstände R 1 und R 2 in weiten Grenzen einstellbar.

Eine mögliche Realisierungsform einer aus Fototransistor, FET und Thyristor bestehenden integrierten Anordnung ist in Fig. 2 dargestellt. Die zum Beispiel n-dotierte Innenzone 1 des Thyristors bildet auch den Kollektor des Fototransistors FT und die Drainzone für den FET. Die katodenseitige Innenzone des Thyristors tritt teilweise an die Oberfläche des Halbleiterkörpers und ist mit 2 bezeichnet. In die Oberfläche des Halbleiterkörpers ist die katodenseitige Emitterzone 3 des Thyristors eingelassen. Sie ist stark n-dotiert. Die Sourcezone des FET wird durch eine Zone 4 gebildet, die ebenfalls an der Oberfläche des Halbleiterkörpers liegt und gleichen Leitfähigkeitstyp wie die Zone 3 hat. Die katodenseitige Innenzone 2 hat einen dünneren Teil 5, der teilweise unter der Sourcezone 4 liegt und bis an die Oberfläche des Halbleiterkörpers reicht. Auf der vom FET abgewandten Seite des Halbleiterkörpers ist eine an die Oberfläche des Halbleiterkörpers angrenzende anodenseitige Emitterzone 11 angeordnet, die beispielsweise stark p-dotiert ist. Diese Emitterzone kann auch an der anderen Oberfläche des Halbleiterkörpers angeordnet sein und der katodenseitigen Emitterzone 3 gegenüberliegen. Im ersten Fall erhält man einen Lateralthyristor, während der zweite Fall einen Vertikalthyristor darstellt.

Die Emitterzone 3 ist durch eine Emitterelektrode 6 kontaktiert. Die Sourcezone 4 des FET ist mit einer Elektrode 7 versehen, über die der Strom in die Sourcezone 4 fliesst. Im gezeigten Ausführungsbeispiel stellt die Elektrode 7 auch den für die du/dt-Festigkeit des Thyristors notwendigen Nebenschluss zwischen Emitterzone 3 und der Basiszone des Thyristors dar, die durch einen Teil der Innenzone 2 gebildet ist. Der Widerstand des Nebenschlusses ist durch den Widerstand R 2 symbolisiert. Für den Fall, dass die Sourcezone des FET (S in Fig. 1) direkt mit der katodenseitigen Emitterzone 3 des Thyristors verbunden sein soll (durchgehende Leitung in Fig. 1), bilden die katodenseitige Emitterzone 3 und die Sourcezone 4 des FET eine einzige Zone. Für diesen Fall ist die Elektrode 7 entbehrlich und der notwendige Nebenschluss wird durch eine die Zone 2 kontaktierende Elektrode 10 hergestellt. Der Widerstand ist auch in diesem Fall mit R 2 bezeichnet. Die Elektrode 10, das heisst der Nebenschluss, muss auf jeden Fall an einer von der Gatezone des FET entfernt liegenden Stelle angeordnet sein. Als entfernt soll eine Entfernung angesehen werden, bei der der Widerstand in der Schicht 2 mindestens 50 Ω beträgt. Der an die Oberfläche des Halbleiterkörpers tretende Teil der Gatezone 5 des FET ist von einer Gateelektrode 9 überdeckt, jedoch durch eine auf der Oberfläche des Halbleiterkörpers liegende Isolierschicht 8 elektrisch von dieser getrennt. Die Isolierschicht 8 kann zum Beispiel aus Siliciumdioxid bestehen. Die Gatezone 5 des FET ist vorzugsweise dünner als die Zone 2, um eine kurze Kanallänge und damit eine hohe Schaltgeschwindigkeit des FET zu ermöglichen.

Der Fototransistor FT weist eine Emitterzone 13 auf, die zum Beispiel stark n-dotiert ist, sowie eine darunterliegende p-dotierte Basiszone 14. Die Emitterzone 13 und die Basiszone 14 sind von einer stark p-dotierten Zone 15 umgeben. Diese dient dazu, den Emitter 13 mit Sicherheit von der Umgebung zu trennen.

An der Oberfläche des Halbleiterkörpers ist eine weitere, die Emitterzone 13 und Basiszone 14 umgebende stark p-dotierte Zone 16 angeordnet, die mit einer Hilfselektrode 17 kontaktiert ist. An diese Hilfselektrode 17 ist eine Hilfsspannung gleicher Polarität wie die Emitterspannung anlegbar. Die Emitterzone 13 ist mit einer Emitterelektrode 18 kontaktiert, die elektrisch mit der Gateelektrode 9 des FET verbunden ist.

Wird an den Thyristor und den Fototransistor eine Spannung der eingezeichneten Polarität angelegt, so erzeugen auf die Oberfläche des Fototransistors auftreffende Lichtstrahlen in der sich in der Zone 1 ausbildenden Raumladungszone Ladungsträgerpaare. Von diesen wandern die Löcher in Richtung auf die Basiszone 14 und verursachen eine Emission von negativen Ladungsträgern aus der Emitterzone 13. Wird die Hilfselektrode 17 an eine gegen Anode negative Spannung gelegt, so bildet sich eine Form der Raumladungszone aus, die ein Abfliessen der lichtelektrisch erzeugten Träger zum FET und zum Thyristor verhindern. Damit wird sichergestellt, dass der grösste Teil der erzeugten Ladungsträger zum Einschalten des Fototransistors beiträgt. Der Emitterstrom fliesst dann durch den Widerstand $R_g$ und den Widerstand R 2 zur Katode. Der Widerstand $R_g$ kann zum Beispiel durch eine Schicht 24 aus polykristallinem Silicium bestehen, die auf die Oberseite der Schicht 8 zwischen Gateelektrode 9 und dem Kontakt 7 aufgedampft ist. Der Widerstand $R_g$ kann zum Beispiel auch eine integrierte Diode sein. Der Strom erzeugt am Widerstand $R_g$ einen Spannungsabfall, der die Gateelektrode 9 des FET positiv vorspannt. Damit bildet sich an dem an die Oberfläche des Halbleiterkörpers grenzenden Teil der Gatezone 5 des FET ein Kanal 22 aus. Durch diesen Kanal fließen nun negative Ladungsträger in die Zone 1 in Richtung auf die anodenseitige Emitterzone 11 des Thyristors zu. Dieser emittiert dann positive Ladungsträger, die zum pn-Übergang 23 diffundieren und im Bereich der Zone 3 eine Emission von negativen Ladungsträgern aus der Zone 3 hervorrufen. Damit wird der pn-Übergang 23 in Durchlaßrichtung vorgespannt und der Thyristor kann zünden.

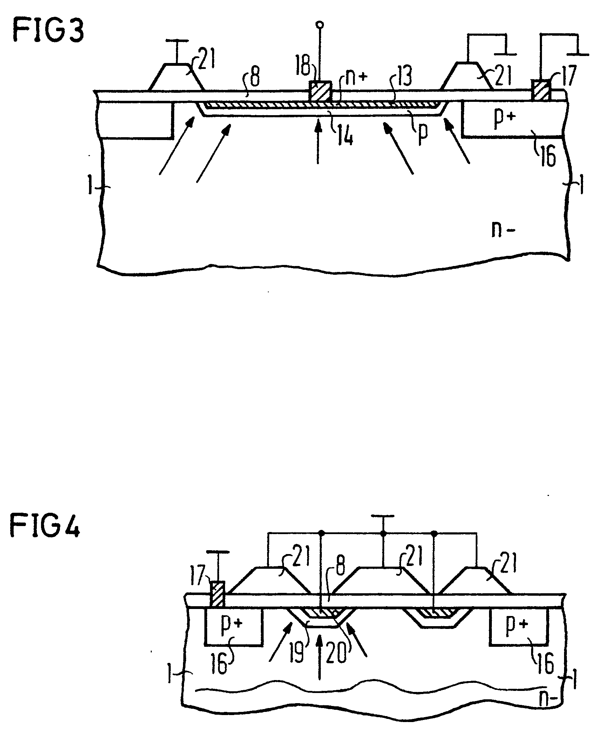

In Fig. 3 ist eine abgewandelte Form des Fototransistors dargestellt, die mit dem FET und dem Thyristor nach Fig. 1 kombiniert werden kann. Der Fototransistor unterscheidet sich von dem nach Fig. 1 hauptsächlich darin, dass die Emitterzone 13 so in die Basiszone 14 eingelassen ist, dass die Basiszone 14 am Rand an die Oberfläche des Halbleiterkörpers anstösst. Dieser Teil der Basiszone 14 und der an die Oberfläche tretende Teil der Kollektorzone ist von Hilfselektroden 21 überdeckt, die gegen die Basiszone und die Kollektorzone durch die Isolierschicht 8 isoliert sind.

Die Hilfselektroden 21 sind an eine Hilfsspannung gleicher Polarität wie die Emitterspannung anlegbar. Bei angelegter Hilfsspannung verformt sich die Raumladungszone in der Zone 1 so, dass die erzeugten Löcher von allen Seiten zur Basis fliessen können, wie dies durch die Pfeile angedeutet ist.

Der Fototransistor nach Fig. 4 unterscheidet sich von dem nach Fig. 3 im wesentlichen dadurch, dass die Emitterzone 13 und die Basiszone 14 in mehrere Teilemitterzonen 20 und diesen zugeordneten Teilbasiszonen 19 aufgeteilt ist. Hierbei sind alle an die Oberfläche des Halbleiterkörpers tretenden Teile der Teilbasiszonen 19 von Hilfselektroden 21 bedeckt. Die Emitterelektroden sind hier der besseren Übersichtlichkeit halber vereinfacht durch Drähte dargestellt. Wird an den Transistor eine Spannung und an die Hilfselektroden 21 die Hilfsspannung angelegt, so bildet sich eine Raumladungszone aus, von der eine Äquipotentiallinie in der Zone 1 angedeutet ist. Die Löcher fliessen dann von allen Seiten, wie durch die Pfeile angedeutet, auf die Teilbasiszonen 19 zu. Die an einer Hilfsspannung liegende Hilfszone 16 dient wieder dazu, den Abfluss der erzeugten Löcher nach aussen zu verhindern. Sie schirmt auch den Fototransistor gegen lichtunabhängige Störströme ab, die in anderen Teilen des Thyristors fliessen können.

Um den Lichteinfall in die Zone 1 möglichst wenig zu stören, werden die Hilfselektroden 21 dünn ausgeführt. Bestehen sie zum Beispiel aus stark n-dotiertem polykristallinem Silicium, so ist eine Dikke von zum Beispiel 0,5 µm ausreichend, da das Silicium in dieser Dicke im wesentlichen durchsichtig ist. Zweckmässigerweise werden die Hilfszone 16 und die Hilfselektroden 21 an dieselbe Hilfsspannung angeschlossen, die zum Beispiel die Emitterspannung sein kann.

Die Zonen 13, 4 und 3 können gleichzeitig zum Beispiel durch eine erste Ionenimplantation hergestellt werden. Mittels einer zweiten Ionenimplantation kann die Basiszone 14 des Fototransistors und die Gatezone 5 des FET hergestellt werden. Die Zonen 15, 16, 2 und 11 werden zweckmässigerweise durch den gleichen Diffusionsschritt erzeugt.

Besonders günstige Ausführungsbeispiele lassen sich mit folgenden Dimensionierungen und Dotierungen erzielen:

Dicke der Mittelzone 1:10 bis 100 µm, Dotierung $10^{14}$ bis $5 \cdot 10^{15}$ $cm^{-3}$; Randdotierung der Zone 2: $10^{16}$ bis $10^{17}$ $cm^{-3}$, Dicke 0,5 bis 5 µm; Dicke der Gatezone 5 und der Basis 14: 0,3 bis 1 µm, Implantation Dosis 2 bis $5 \cdot 10^{12}$ $cm^{-2}$, Energie 150 bis 200 keV; Dicke der Zonen 3, 4, 13: 0,1 bis 1 µm, Arsen-Implantation Dosis $10^{15}$ bis $10^{16}$ $cm^{-2}$, Energie 100 bis 150 keV; Dicke der Hilfselektroden 21: 0,4 bis 1 µm, Breite der Teilemitterzonen 20: 5 bis 20 µm, Abstand 20 bis 50 µm; laterale Ausdehnung der Anordnung zum Beispiel 100 bis 200 µm, Dicke der Anordnung etwa 250 bis 500 µm.

Für grössere Leistungen empfiehlt es sich, die beschriebene Anordnung im Vielfach auf einem einzigen Chip nach Art einer integrierten Schaltung anzuordnen und die jeweiligen Spannungen durch entsprechende Leiterbahnen zuzuführen. Mit angegebenen Abmessungen ist auch die eingangs erwähnte Bedingung für die Kapazitäten erfüllt.

## Patentansprüche

1. Lichtsteuerbare Anordnung aus einem in einen Halbleiterkörper integrierten Thyristor (Th) mit einer anodenseitigen (11) und einer katodenseitigen Emitterzone (3) und zwei zwischen den Emitterzonen liegenden Innenzonen (1, 2), und aus einer in den Halbleiterkörper integrierten, durch Licht steuerbaren stromverstärkenden Anordnung, deren Ausgang mit dem Steuereingang des Thyristors (Th) verbunden ist, wobei mindestens die katodenseitige Emitterzone (3) durch einen Nebenschluss elektrisch mit der angrenzenden inneren Zone (2) verbunden ist, dadurch gekennzeichnet, dass die durch Licht steuerbare, stromverstärkende Anordnung aus einem Fototransistor (FT) und einem Feldeffekttransistor (FET) besteht, dessen Gateeingang (G) mit dem Ausgang des Fototransistors verbunden ist.

2. Lichtsteuerbare Anordnung nach Anspruch 1, dadurch gekennzeichnet, dass die Sourcezone (S) des FET durch eine an der Oberfläche des Halbleiterkörpers liegende Zone (4) gleichen Leitfähigkeitstyps wie die katodenseitige Emitterzone (3) des Thyristors gebildet ist, dass die Drainzone (D) des FET ein an die Oberfläche des Halbleiterkörpers tretender Teil der anodeneitigen Innenzone (1) ist, dass die Gatezone des FET durch einen sich bis zur Oberfläche des Halbleiterkörpers erstreckenden, zwischen Sourcezone und Drainzone liegenden Teil (5) der katodenseitigen Innenzone (2) gebildet ist; dass auf der vom Thyristor (Th) abgewandten Seite des FET eine weitere an der Oberfläche des Halbleiterkörpers liegende, den Emitter des Fototransistors bildende Zone (13) vom gleichen Leitfähigkeitstyp wie die katodenseitige Emitterzone (3) des Thyristors angeordnet ist, dass unter dieser eine dem Fototransistor zugeordnete Basiszone (14) entgegengesetzten Leitfähigkeitstyps liegt; dass die Emitterzone (13) des Transistors durch eine Emitterelektrode (18) kontaktiert ist, dass der an die Oberfläche tretende Teil der Gatezone (5) der FET von einer gegen die Gatezone elektrisch isolierten Gateelektrode (9) überdeckt ist; und dass die Emitterzone (13) des Fototransistors (FT) und die Gateelektrode (9) des FET elektrisch miteinander verbunden sind.

3. Lichtsteuerbare Anordnung nach Anspruch 2, dadurch gekennzeichnet, dass die katodenseitige Emitterzone (3) des Thyristors und die Sourcezone (4) des FET eine einzige zusammenhängende Zone bilden.

4. Lichtsteuerbare Anordnung nach einem der beiden Ansprüche 2 oder 3, dadurch gekennzeichnet, dass die anodenseitige Emitterzone (11) des

Thyristors an die gleiche Oberfläche des Halbleiterkörpers angrenzt wie die katodenseitige Emitterzone (3), und dass sie auf der dem FET abgewandten Seite der katodenseitigen Emitterzone (3) liegt.

5. Lichtsteuerbare Anordnung nach einem der beiden Ansprüche 2 oder 3, dadurch gekennzeichnet, dass die anodenseitige Emitterzone (11) des Thyristors an die der katodenseitigen Emitterzone (3) gegenüberliegende Oberfläche des Halbleiterkörpers angrenzt und der katodenseitigen Emitterzone (3) gegenüberliegt.

6. Lichtsteuerbare Anordnung nach Anspruch 2, dadurch gekennzeichnet, dass die Emitter- und Basiszone (13, 14) des Fototransistors von einer Hilfszone (16) umgeben ist, die gleichen Leitfähigkeitstyp wie die Basiszone (14) des Fototransistors (FT), jedoch höhere Dotierung hat, und dass diese Hilfszone (16) an eine Hilfsspannung anschliessbar ist, die gleiche Polarität wie die Emitterspannung hat.

7. Lichtsteuerbare Anordnung nach Anspruch 2, dadurch gekennzeichnet, dass die Emitter- und Basiszone (13, 14) des Fototransistors in Form einer Planarstruktur in die Oberfläche des Halbleiterkörpers eingelassen sind und dass die an die Oberfläche tretenden Teile der Basiszone (14) und der Kollektorzone (1) des Fototransistors (FT) von einer elektrisch gegen diese isolierten Hilfselektrode (21) überdeckt werden, die an eine Hilfsspannung gleicher Polarität wie die Emitterspannung anschliessbar ist.

8. Lichtsteuerbare Anordnung nach Anspruch 7, dadurch gekennzeichnet, dass die Emitter- und Basiszone des Fototransistors in räumlich voneinander beabstandete Teilemitterzonen (20) und Teilbasiszonen unterteilt ist und dass alle an die Oberfläche tretenden Teile der Teilbasiszonen (19) von den Hilfselektroden (21) überdeckt sind, und dass jeweils alle Hilfselektroden (21) und alle Teilemitterzonen (20) elektrisch miteinander verbunden sind.

9. Lichtsteuerbare Anordnung nach einem der Ansprüche 6 bis 8, dadurch gekennzeichnet, dass die Hilfselektroden (21), die Hilfszone (16) und die Emitterzonen (13, 20) an der gleichen Spannung liegen.

10. Lichtsteuerbare Anordnung nach einem der Ansprüche 1 bis 9, dadurch gekennzeichnet, dass die Emitterzone (13, 20) des Fototransistors, die Sourcezone (4) des FET und die katodenseitige Emitterzone (3) des Thyristors durch einen ersten, die Basiszone (14) des Fototransistors und die Gatezone (5) des FET durch einen zweiten Ionenimplantationsschritt hergestellt sind.

## Claims

1. A light-controllable arrangement comprising a thyristor(Th) which is integrated into a semiconductor body and has an anode-side emitter zone (11) and a cathode-side emitter zone (3), and two inner zones (1,2) which are arranged between the emitter zones, and a light-controllable, current-amplifying arrangement which is integrated into the semiconductor body, the output of which is connected to the control input of the thyristor (Th), at least the cathode-side emitter zone (3) being electrically connected to the adjacent inner zone (2) by a shunt, characterised in that the light-controllable, current-amplifying arrangement consists of a phototransistor (FT) and a field-effect transistor (FET), the gate input (G) of which is connected to the output of the phototransistor.

2. A light-controllable arrangement according to claim 1, characterised in that the source zone (S) of the FET is formed by a zone (4) which lies at the surface of the semiconductor body and is of the same conductivity type as the cathode-side emitter zone (3) of the thyristor; that the drain zone (D) of the FET is a part of the anode-side inner zone (1) which extends to the surface of the semiconductor body; that the gate zone of the FET is formed by a part (5) of the cathode-side inner zone (2) which extends to the surface of the semiconductor body and is arranged between the source zone and the drain zone; that on the side of the FET remote from the thyristor (Th) there is arranged a further zone (13) of the same conductivity type as the cathode-side emitter zone (3) of the thyristor, which zone (13) lies at the surface of the semiconductor body and forms the emitter of the phototransistor; that below the emitter zone (3), there is arranged a base zone (14) of the opposite conductivity type which is assigned to the phototransistor; that the emitter zone (13) of the transistor is contacted by an emitter electrode (18); that the part of the gate zone (5) of the FET which extends to the surface is overlapped by a gate electrode (9) which is electrically insulated from the gate zone; and that the emitter zone (13) of the phototransistor (FT) and the gate electrode (9) of the FET are electrically interconnected.

3. A light-controllable arrangement according to claim 2, characterised in that cathode-side emitter zone (3) of the thyristor and the source zone (4) of the FET form a single continuous zone.

4. A light-controllable arrangement according to claim 2 or 3, characterised in that the anode-side emitter zone (11) of the thyristor borders on the same surface of the semiconductor body as the cathode-side emitter zone (3); and that it is arranged on the side of the cathode-side emitter zone (3) remote from the FET.

5. A light-controllable arrangement according to claim 2 or 3, characterised in that the anode-side emitter zone (11) of the thyristor borders on the surface of the semiconductor body which lies opposite the cathode-side emitter zone (3) and is arranged opposite to the cathode-side emitter zone (3).

6. A light-controllable arrangement according to claim 2, characterised in that the emitter zone (13) and the base zone (14) of the phototransistor are surrounded by an auxiliary zone (16) which has the same conductivity type as the base zone (14) of the phototransistor (FT) but

a higher doping; and that the auxiliary zone (16) can be connected to an auxiliary voltage which has the same polarity as the emitter voltage.

7. A light-controllable arrangement according to claim 2, characterised in that the emitter zone (13) and the base zone (14) of the phototransistor are introduced into the surface of the semiconductor body in the form of a planar structure; and that the parts of the base zone (14) and of the collected zone (1) of the phototransistor (FT) are covered by an auxiliary electrode (21) which is electrically insulated from said zones, and which can be connected to an auxiliary voltage of the same polarity as the emitter voltage.

8. A light-controllable arrangement according to claim 7, characterised in that the emitter zone and the base zone of the phototransistor are divided into partial emitter zones (20) and partial base zones which are spaced from one another; that all parts of the partial base zone (19) which extend to the surface are covered by the auxiliary electrodes (21); and that all the auxiliary electrodes (21) and all the partial emitter zones (20) are electrically interconnected.

9. A light-controllable arrangement according to one of claims 6 to 8, characterised in that the auxiliary electrodes (21), the auxiliary zone (16) and the emitter zones (13, 20) are connected to the same voltage.

10. A light-controllable arrangement according to one of claims 1 to 9, characterised in that the emitter zone (13, 20) of the phototransistor, the source zone (4) of the FET and the cathode-side emitter zone (3) of the thyristor are produced by a first ion implantation step, and the base zone (14) of the phototransistor and the gate zone (5) of the FET are produced by a second ion implantation step.

## Revendications

1. Dispositif à commande optique constitué par un thyristor (Th), intégré dans un corps semi-conducteur avec une zone d'émetteur (11) située du côté de l'anode et une zone d'émetteur (3) située du côté de la cathode et deux zones intérieures (1, 2) situées entre les zones d'émetteur, et par un dispositif intégré dans le corps semi-conducteur, susceptible d'être commandé par la lumière, amplifiant le courant et dont la sortie est reliée à l'entrée de commande du thyristor (Th), au moins la zone d'émetteurs (3), située du côté de la cathode, étant reliée par une dérivation électrique à la zone intérieure voisine (2), caractérisé par le fait que le dispositif susceptible d'être commandé par la lumière et amplifiant le courant est constitué par un phototransistor (FT) et par un transistor à effet de champ (FET) dont l'entrée de grille (G) est reliée à la sortie du phototransistor.

2. Dispositif à commande optique selon la revendication 1, caractérisé par le fait que la zone de source (S) du FET est formée par une zone (4) qui se situe à la surface du corps semi-conducteur et qui possède le même type de conductivité que la zone d'émetteurs (3) du thyristor, située du côté de la cathode, que la zone de drain (D) du FET est constituée par une partie de la zone intérieure (1), située du côté de l'anode et apparaissant dans la surface du corps semi-conducteur, que la zone de grille du FET est constituée par une partie (5) de la zone intérieure (2), située du côté de la cathode et s'étendant jusqu'à la surface du corps semi-conducteur, entre la zone de source et la zone de drain, que, du côté du FET qui est éloigné du thyristor (Th), est prévue une zone supplémentaire (13) se situant sur la surface du corps semi-conducteur et constituant l'émetteur du phototransistor, ladite zone (13) étant du même type de conductivité que la zone (3) du thyristor, située du côté de la cathode, que sous cette zone d'émetteur (3) est située une zone de base (14) associée au phototransistor et du type de conductivité opposé, que la zone d'émetteur (13) du transistor est contactée par une électrode d'émetteur (18), que la partie de la zone de grille (5) du FET, qui apparaît à la surface, est recouverte d'une électrode de grille (9) électriquement isolée par rapport à la zone de grille, et que la zone d'émetteurs (13) du phototransistor (FT) et l'électrode de grille (9) du FET sont reliées électriquement entre elles.

3. Dispositif à commande optique selon la revendication 2, caractérisé par le fait que la zone d'émetteur (3) du thyristor, qui est située du côté de la cathode, et la zone de source (4) du FET constituent une zone unique et d'un seul tenant.

4. Dispositif à commande optique selon l'une des revendications 2 ou 3, caractérisé par le fait que la zone d'émetteur (11) du thyristor, située du côté de l'anode, jouxte la même surface du corps semi-conducteur que la zone d'émetteur (3) située du côté de la cathode, et qu'elle est située sur le côté de la zone d'émetteur (3) voisine de la cathode, qui est éloignée du FET.

5. Dispositif à commande optique selon l'une des revendications 2 ou 3, caractérisé par le fait que la zone d'émetteur (11) du thyristor, située du côté de l'anode, jouxte la surface du corps semi-conducteur qui se trouve en face de la zone d'émetteur (3) située du côté de la cathode et se trouve en face de la zone d'émetteur (3) qui se situe du côté de la cathode.

6. Dispositif à commande optique selon la revendication 2, caractérisé par le fait que la zone d'émetteur et de base (13, 14) du phototransistor est entourée d'une zone auxiliaire (16) qui a le même type de conductivité que la zone de base (14) du phototransistor (FT), mais un dopage plus élevé, et que cette zone auxiliaire (16) est susceptible d'être reliée à une tension auxiliaire qui a la même polarité que la tension d'émetteurs.

7. Dispositif à commande optique selon la revendication 2, caractérisé par le fait que les zones d'émetteur et de base (13, 14) du phototransistor sont noyées dans la surface du corps semi-conducteur sous la forme d'une structure plane et

que les parties de la zone de base (14) et de la zone de collecteur (1) du phototransistor (FT), qui apparaissent à la surface, sont recouvertes par une électrode auxiliaire (21) isolée électriquement par rapport à elles, électrode auxiliaire qui est susceptible d'être reliée à une tension auxiliaire de même polarité que la tension d'émetteurs.

8. Dispositif à commande optique selon la revendication 7, caractérisé par le fait que la zone d'émetteur et de base du phototransistor est subdivisée en zones d'émetteurs partielles (20) et en zones de base partielles, espacées spatialement entre elles, et que toutes les parties de la zone de base partielle (19) qui apparaissent à la surface sont recouvertes par des électrodes auxiliaires (21) et que toutes les électrodes auxiliaires (21) et toutes les électrodes d'émetteur partielles (20) sont respectivement reliées entre elles.

9. Dispositif à commande optique selon l'une des revendications 6 à 8, caractérisé par le fait que les électrodes auxiliaires (21), la zone auxiliaire (16) et les zones d'émetteur (13, 20) sont à la même tension.

10. Dispositif à commande optique selon l'une des revendications 1 à 9, caractérisé par le fait que la zone d'émetteur (13, 20) du phototransistor, la zone de source (4) du FET et la zone d'émetteur (3) du thyristor, qui est située du côté de la cathode, sont réalisées par une première phase opératoire par implantation d'ions et la zone de base (14) du phototransistor et la zone de grille (5) du FET par une seconde phase opératoire par implantation d'ions.

FIG1

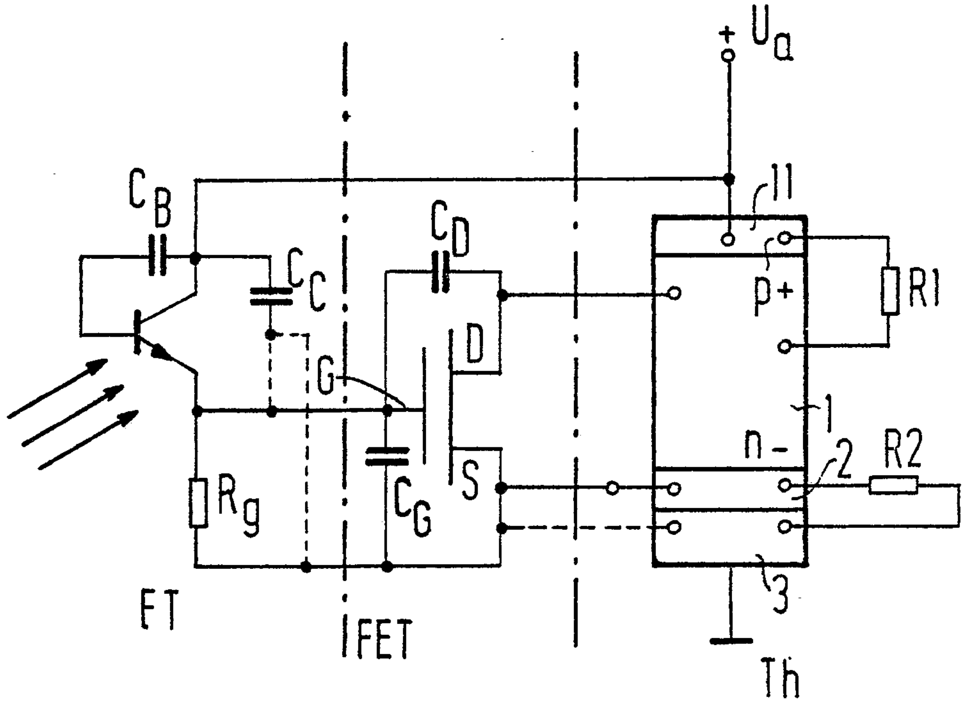

FIG2

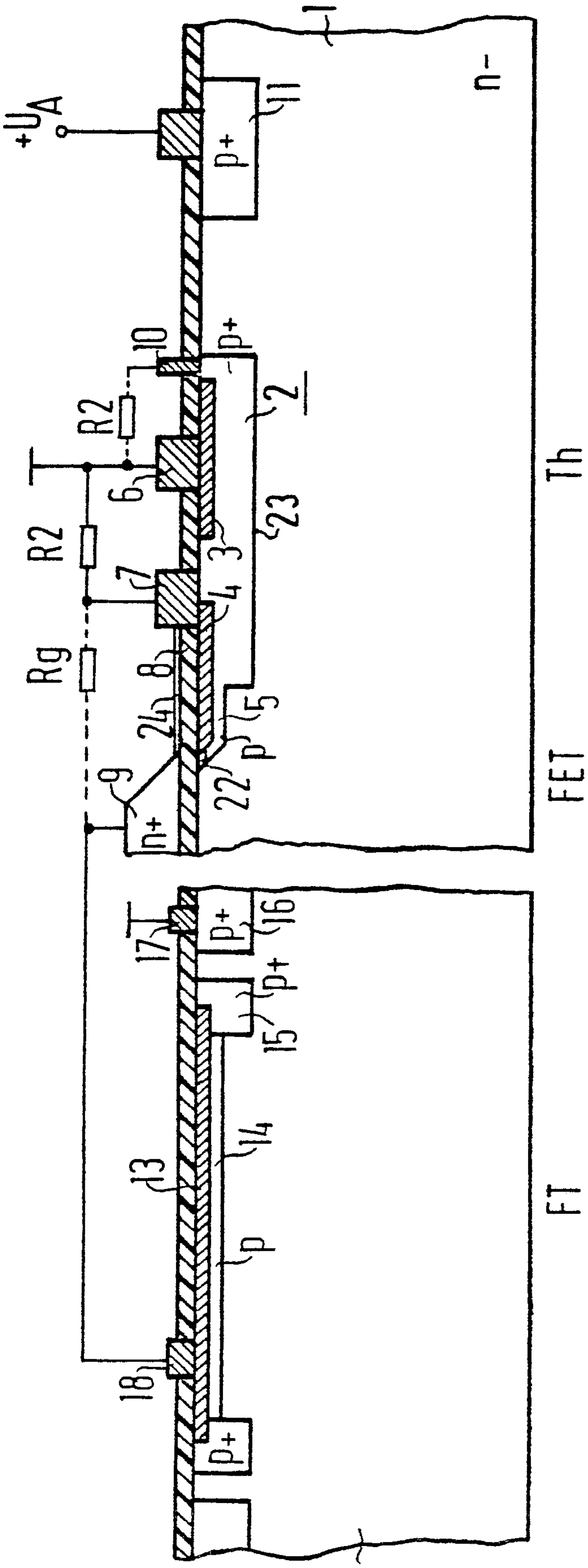
+U
A
p+
11
n-
1
10
p+
R2
R2
6
7
3
4
23
2
Th
Rg
8
24
5
9
n+
22
p
FET
17
16
p+
p+
15
13
14
p
FT
18
p+
1

FIG3

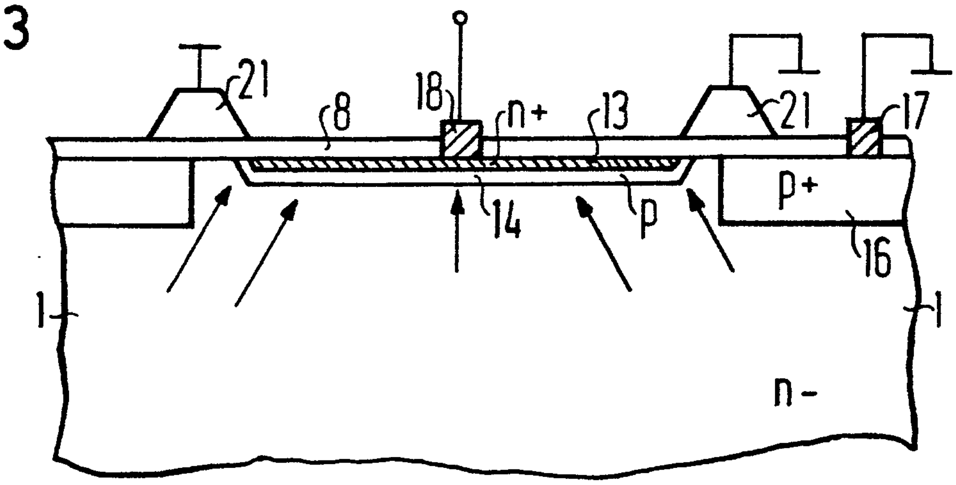


FIG4